# EUROPEAN PATENT APPLICATION

(11) **EP 4 712 736 A2**
(43) Date of publication of application: **18.03.2026**
(21) Application number: 26154818.4
(22) Date of filing: 22.09.2023
(51) Int. Cl.: H10F 19/80

(54) **BACK-CONTACT PHOTOVOLTAIC MODULE AND MANUFACTURING METHOD THEREOF**

(30) Priority: 24.04.2023 CN 202310458880
(62) Divisional of application: 23198994.8
(71) Applicant: Jinko Solar (Haining) Co., Ltd., Haining, Zhejiang 314415 (CN); Zhejiang Jinko Solar Co., Ltd., Haining, Zhejiang 314416 (CN)
(72) Inventor: TAO, Wusong, Huangwan Town, Haining, Jiaxing, Zhejiang 314415 (CN); WANG, Luchuang, Huangwan Town, Haining, Jiaxing, Zhejiang 314415 (CN); HUANG, Shiliang, Huangwan Town, Haining, Jiaxing, Zhejiang 314415 (CN); GUO, Zhiqiu, Huangwan Town, Haining, Jiaxing, Zhejiang 314415 (CN)
(74) Representative: DREISS Patentanwälte PartG mbB

(57) **Abstract**

The present disclosure provides a back-contact photovoltaic module and a manufacturing method thereof. The back-contact photovoltaic module includes a glass substrate, an upper adhesive film layer, a solar cell layer, a lower adhesive film layer, and a back sheet arranged in sequence from top to bottom. The solar cell layer includes back-contact solar cells, and a front surface of each of the back-contact solar cells is provided with a transparent support layer. The transparent support layer protrudes from a surface of the back-contact solar cell, and the transparent support layer covers a partial region of the front surface. According to the present disclosure, the front surface of the back-contact solar cell can be protected, and a risk of scratches to the back-contact photovoltaic module can be reduced.

## Description

The present application is a divisional application of European Patent Application No. 23198994.8, filed on September 22, 2023 to the European Patent Office.

### TECHNICAL FIELD

The present disclosure relates to the technical field of photovoltaic manufacturing, and in particular, to a back-contact photovoltaic module and a manufacturing method thereof.

### BACKGROUND

PN junctions and electrodes of a back-contact solar cell are located on a back surface of the cell. In other words, electrodes in emitter and base regions of the back-contact solar cell are all on the back surface, and a front surface is not shielded by gate lines, which can significantly improve photoelectric conversion performance of the solar cell and bring high cell efficiency and great development potential. Since the front surface of the back-contact solar cell is not shielded by the gate lines, a front film layer is directly in contact with a transfer table, which easily causes scratches during the transfer of the back-contact solar cell and affects an appearance of the solar cell.

### SUMMARY

The present disclosure provides a back-contact photovoltaic module and a manufacturing method thereof, so as to protect the front surface of the back-contact solar cell and reduce a risk of scratches to the back-contact photovoltaic module.

In a first aspect of the present disclosure, a back-contact photovoltaic module is provided, including a glass substrate, an upper adhesive film layer, a solar cell layer, a lower adhesive film layer, and a back sheet arranged in sequence from top to bottom; and

the solar cell layer includes back-contact solar cells, and a front surface of each of the back-contact solar cells is provided with a transparent support layer, the transparent support layer protruding from a surface of the back-contact solar cell, and the transparent support layer covering a partial region of the front surface.

In some embodiments, an area ratio of the transparent support layer to the front surface ranges from 1% to 80%.

In some embodiments, the transparent support layer includes transparent bumps.

In some embodiments, the transparent bumps are evenly distributed on the surface of the back-contact solar cell.

In some embodiments, a number of the transparent bumps is equal to or more than 9;
or an interval between adjacent transparent bumps is equal to or less than 7 cm.

In some embodiments, a projected area of the transparent bumps on the surface of the back-contact solar cell is less than 10 mm².

In some embodiments, a height of each of the transparent bumps is less than 0.5 mm.

In some embodiments, a gap is provided between each of the transparent bumps and an edge of each of the back-contact solar cells.

In some embodiments, the transparent support layer is made of any one of an insulating adhesive, a hot melt adhesive, polyethylene terephthalate (PET), ethyl vinyl acetate (EVA), and polyolefin elastomer (POE).

In some embodiments, a side of the upper adhesive film layer facing the back-contact solar cell is provided with a groove, the groove fitting the transparent support layer.

In a second aspect of the present disclosure, a method for manufacturing a back-contact photovoltaic module is provided, wherein the back-contact photovoltaic module includes a glass substrate, an upper adhesive film layer, a solar cell layer, a lower adhesive film layer, and a back sheet arranged in sequence from top to bottom; and
the solar cell layer includes back-contact solar cells, and a front surface of each of the back-contact solar cells is provided with a transparent support layer, the transparent support layer protruding from a surface of the back-contact solar cell, and the transparent support layer covering a partial region of the front surface; and the manufacturing method includes:
making the front surface of the back-contact solar cell face upwards, and manufacturing the transparent support layer on the front surface of the back-contact solar cell; curing the transparent support layer; turning the back-contact solar cell over for transfer; and packaging the back-contact solar cells to form the back-contact photovoltaic module.

It should be understood that the general description above and the detailed description in the following are merely exemplary, and cannot limit the present disclosure.

### BRIEF DESCRIPTION OF DRAWINGS

FIG. 1 is a schematic structural diagram of a back-contact photovoltaic module according to some embodiments of the present disclosure;
FIG. 2 is a schematic structural diagram of a back-contact solar cell according to some embodiments of the present disclosure;
FIG. 3 is a schematic structural diagram of a transparent support layer according to some embodiments of the present disclosure;
FIG. 4 is another schematic structural diagram of a transparent support layer according to some embodiments of the present disclosure;
FIG. 5 is a schematic structural diagram of a front surface of a back-contact solar cell according to some embodiments of the present disclosure;
FIG. 6 is a schematic structural diagram of a front surface of another back-contact solar cell according to some embodiments of the present disclosure;
FIG. 7 is a schematic diagram of a distribution structure of transparent bumps according to some embodiments of the present disclosure;
FIG. 8 is a schematic diagram of another distribution structure of transparent bumps according to some embodiments of the present disclosure;
FIG. 9 is a schematic diagram of a fitting structure of an upper adhesive film layer and a transparent support layer according to some embodiments of the present disclosure; and
FIG. 10 is a flowchart of a back-contact photovoltaic module according to some embodiments of the present disclosure.

### Reference signs:

1: glass substrate;
2: upper adhesive film layer;
   21: groove;
3: solar cell layer;
   31: back-contact solar cell;
      311: base;
      312: doping layer;
         3121: first doping region;
         3122: second doping region;
      313: first passivation layer;
      314: first antireflection layer;
      315: second passivation layer;
      316: second antireflection layer;
      317: first electrode;
      318: second electrode;
   32: cutting line;
4: lower adhesive film layer;
5: back sheet;
6: frame;
7: transparent support layer;
   71: transparent bump.

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to make the objectives, technical solutions, and advantages of the present disclosure clearer, the present disclosure is described in further detail below with reference to the accompanying drawings and embodiments. It should be understood that specific embodiments described herein are intended only to interpret the present disclosure and not intended to limit the present disclosure.

In the description of the present disclosure, unless otherwise clearly stated and limited, the terms "first" and "second" are used for descriptive purposes only, which cannot be construed as indicating or implying a relative importance. Unless otherwise specified or stated, the term "a plurality of" means two or more. The terms "connection" and "fixing" should be understood in a broad sense. For example, "connection" may be a fixed connection, a detachable connection, or an integral connection; or an electrical connection; or a direct connection or an indirect connection through an intermediate medium. For those of ordinary skill in the art, the specific meanings of the foregoing terms in the present disclosure can be understood on a case-by-case basis.

In the description of the present disclosure, it is to be understood that orientation terms such as "up" and "down" described in the embodiments of the present disclosure are described from the perspective shown in the accompanying drawings, and should not be construed as limiting the embodiments of the present disclosure. Besides, in this context, it is to be further understood that one element described as being connected "on" or "under" another element not only means that the element may be directly connected "on" or "under" the another element, but also means that the element may be indirectly connected "on" or "under" the another element through an intermediate element.

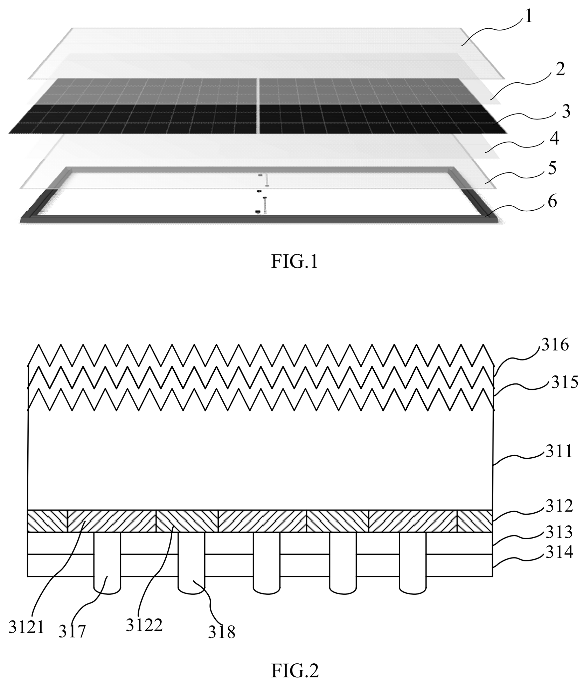

As shown in FIG. 1 to FIG. 9, some embodiments of the present disclosure provide a back-contact photovoltaic module, including a glass substrate 1, an upper adhesive film layer 2, a solar cell layer 3, a lower adhesive film layer 4, and a back sheet 5 arranged in sequence from top to bottom. The glass substrate 1 and the upper adhesive film layer 2 are arranged on a front surface of the solar cell layer 3 (i.e., a light-receiving surface of the solar cell layer 3). The lower adhesive film layer 4 and the back sheet 5 are arranged on a back surface of the solar cell layer 3 (i.e., a backlight surface of the solar cell layer 3). The upper adhesive film layer 2 and the lower adhesive film layer 4 may be made of a same material or different materials. In some embodiments, the material includes EVA, POE, PVB, and the like. The glass substrate 1, the upper adhesive film layer 2, the solar cell layer 3, the lower adhesive film layer 4, and the back sheet 5 are laminated and packaged to form a photovoltaic module that can be used outdoors for a long time. The back-contact photovoltaic module may further include a frame 6 and a junction box. The frame 6 is arranged on an edge of the back-contact photovoltaic module to enhance structural strength of the module, prolong the service life of the module, and facilitate transportation, mounting, and fixing of the module. The junction box connects a circuit of the back-contact photovoltaic module and an external load circuit to realize transfer of electric energy.

In an embodiment, the solar cell layer 3 includes back-contact solar cells 31. Each back-contact solar cell 31 includes a front surface and a back surface arranged oppositely. The back surface refers to a side of the back-contact solar cell 31 provided with a gate line, and the front surface refers to a side of the back-contact solar cell 31 provided with no gate line.

For example, referring to FIG. 2, the back-contact solar cell 31 includes a base 311. A back surface of the base 311 is sequentially provided with a doping layer 312, a first passivation layer 313, and a first antireflection layer 314, a front surface of the base 311 is sequentially provided with a second passivation layer 315 and a second antireflection layer 316, the first antireflection layer 314 forms a surface of the front surface of the back-contact solar cell 31, and the second antireflection layer 316 forms a surface of the back surface of the back-contact solar cell 31. The doping layer 312 includes a first doping region 3121 and a second doping region 3122. Doping types of the first doping region 3121 and the second doping region 3122 are opposite. For example, the first doping region 3121 is an N-type doping region, and the second doping region 3122 is a P-type doping region. The first doping region 3121 is connected to a first electrode 317, and the first electrode 317 passes through the first passivation layer 313 and the first antireflection layer 314 and is exposed to the surface of the back-contact solar cell. The second doping region 3122 is connected to a second electrode 318, and the second electrode 318 passes through the first passivation layer 313 and the first antireflection layer 314 and is exposed to the surface of the back-contact solar cell. In some embodiments, a tunnel oxide layer and a doped polysilicon layer may also be provided between the base 311 and the doping layer 312. One or more doped polysilicon layers are provided.

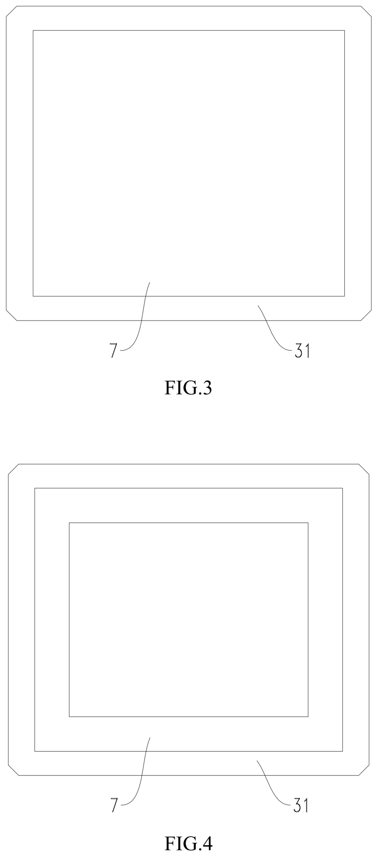

Referring to FIG. 3 to FIG. 8, further, the front surface of the back-contact solar cell 31 is provided with a transparent support layer 7. That is, the transparent support layer 7 is attached to the surface of the front surface of the back-contact solar cell 31. The transparent support layer is only required to be manufactured on the front surface of the back-contact solar cell 31 in a use process (for example, a process of using the back-contact solar cell 31 to manufacture the photovoltaic module), without changing an original structure and a manufacturing process of the back-contact solar cell 31, which can effectively reduce manufacturing costs.

In an embodiment, the transparent support layer 7 is made of a transparent material, so that the incident light can pass therethrough smoothly. The transparent support layer 7 protrudes from the surface of the front surface of the back-contact solar cell 31. When the front surface of the back-contact solar cell 31 is transferred downwards, the transparent support layer 7 separates the back-contact solar cell 31 from a transfer table, the transparent support layer 7 is in contact with the transfer table, and a gap is formed between the front surface of the back-contact solar cell 31 and the transfer table, so that the transparent support layer 7 protects the front surface of the back-contact solar cell 31, which prevents direct contact of the surface of the back-contact solar cell 31 with the transfer table, thereby reducing a risk of scratches to the back-contact photovoltaic module.

In an embodiment, the transparent support layer 7 covers a partial region of the front surface. That is, the transparent support layer 7 does not completely cover the front surface of the back-contact solar cell 31. For example, the transparent support layer 7 accounts for no more than 95% of an area of the front surface, which further reduces absorption of the incident light by the transparent support layer 7, thereby improving conversion efficiency of solar energy.

Preferably, the transparent support layer 7 accounts for 1% to 80% of the area of the front surface. For example, the transparent support layer accounts for 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, or 80% of the area of the front surface, which can effectively protect the front surface of the back-contact solar cell 31 and can also ensure that the front surface of the back-contact solar cell 31 has sufficiently high transmittance, thereby improving the conversion efficiency of the solar energy. When the transparent support layer 7 accounts for less than 1% of the area of the front surface, the area of the transparent support layer 7 is excessively small. Due to influences of factors such as unevenness of the transfer table, possible bending of the back-contact solar cell 31, and vibration or shaking generated during the transfer, the transparent support layer 7 cannot effectively protect the front surface of the back-contact solar cell 31, and the partial region of the front surface of the back-contact solar cell 31 may still be in contact with the transfer table. When the transparent support layer 7 accounts for more than 80% of the area of the front surface, the area of the transparent support layer 7 is excessively large, so that great losses are generated when light passes through the transparent support layer 7, resulting in low transmittance.

More preferably, the transparent support layer 7 accounts for 2% to 30% of the area of the front surface. For example, the transparent support layer 7 accounts for 2%, 3%, 4%, 5%, 6%, 7%, 8%, 9%, 10%, 12%, 15%, 18%, 20%, 23%, 25%, 28%, or 30% of the area of the front surface. Within the range, the front surface of the back-contact solar cell 31 can be reliably protected, and the front surface of the back-contact solar cell 31 can be guaranteed to have higher transmittance as much as possible, thereby improving the conversion efficiency of the solar energy.

The transparent support layer 7 may be arranged as a continuous structure or a discrete structure.

When the transparent support layer 7 is arranged as the continuous structure, the transparent support layer 7 may be arranged in any suitable shape such as a rectangle, a circle, a ring, a zigzag, a curve or an irregular shape. Preferably, the transparent support layer 7 is arranged as a rectangular structure (refer to FIG. 3) or a rectangular ring structure (refer to FIG. 4). The transparent support layer 7 is arranged in a center of the back-contact solar cell 31, and a uniform interval is formed between an edge of the transparent support layer 7 and an edge of the back-contact solar cell 31, so that the transparent support layer 7 can provide uniform and stable support for the back-contact solar cell 31.

When the transparent support layer 7 is arranged as the discrete structure, the transparent support layer 7 may include support portions spaced apart from each other. Each support portion protrudes from the surface of the back-contact solar cell 31, and the plurality of support portions jointly form the transparent support layer 7. The plurality of support portions may be evenly distributed on the surface of the back-contact solar cell 31 in a rectangular array or an annular array, and the plurality of support portions may alternatively be unevenly distributed on the surface of the back-contact solar cell 31 in a random manner. It may be understood that each support portion may be arranged in any suitable shape such as a rectangle, a circle, a ring, a zigzag, a curve or an irregular shape.

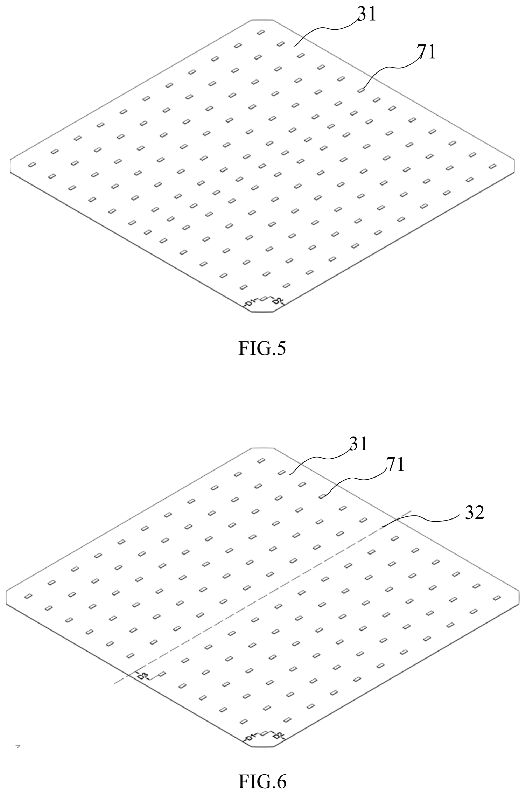

Referring to FIG. 5 to FIG. 8, further, the transparent support layer 7 includes transparent bumps 71, the transparent bumps 71 protrude from the surface of the back-contact solar cell 31, and the plurality of transparent bumps 71 are distributed at intervals on the surface of the back-contact solar cell 31. On the one hand, the transparent bumps 71 form scattered small-area shields on the front surface of the back-contact solar cell 31, thereby reducing the losses generated when the light passes through the transparent support layer 7. On the other hand, each transparent bump 71 can form a support point for the back-contact solar cell 31, and the plurality of transparent bumps 71 form scattered support points for the back-contact solar cell31, so as to provide stable support for the back-contact solar cell 31 and prevent shaking of the back-contact solar cell 31 during the transfer.

In an embodiment, the transparent bumps 71 are evenly distributed on the surface of the back-contact solar cell 31. On the one hand, the evenly distributed transparent bumps 71 can form uniform shields on the front surface of the back-contact solar cell 31, so that the incident light is uniformly distributed on the front surface of the back-contact solar cell 31. On the other hand, the evenly distributed transparent bumps 71 can form uniform support points on the front surface of the back-contact solar cell 31, so that each transparent bump 71 can bear a load evenly, which prevents local damages caused by an uneven force on the back-contact solar cell 31. It may be understood that the transparent bumps 71 may alternatively be unevenly distributed on the surface of the back-contact solar cell 31. For example, the plurality of transparent bumps 71 may be unevenly distributed on the surface of the back-contact solar cell 31 in a random manner.

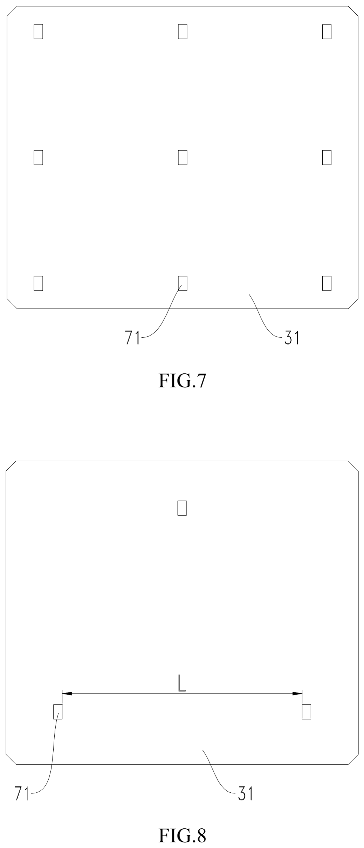

In some embodiments, referring to FIG. 7, the transparent bumps 71 are evenly distributed on the surface of the back-contact solar cell 31 according to a rectangular array, and two mutually perpendicular sides of the back-contact solar cell 31 respectively form rows and columns of the rectangular array, so that the arrangement of the transparent bumps 71 is compatible with the structure of the back-contact solar cell 31.

When the plurality of transparent bumps 71 are unevenly distributed according to the rectangular array, a number of the transparent bumps 71 is no less than 9. Taking 9 transparent bumps 71 as an example for detailed illustration, the 9 transparent bumps 71 are distributed in a 3X3 rectangular array. That is, three transparent bumps 71 are arranged on each side of the back-contact solar cell 31, and one transparent bump 71 is arranged in the center, so as to form support for edge and central parts of the back-contact solar cell 31, which effectively prevent possible contact of the partial region of the back-contact solar cell 31 with the transfer table.

In some other embodiments, referring to FIG. 8, a size of the back-contact solar cell 31 is small, and the number of the transparent bumps 71 is less than 9, for example 3. The plurality of transparent bumps 71 are unevenly distributed on the surface of the back-contact solar cell 31, so that each transparent bump 71 forms an effective region as large as possible, which reduces the number of the transparent bumps 71 on the surface of the back-contact solar cell 31, thereby reducing the light absorbed by the transparent bumps 71. An interval L between adjacent transparent bumps 71 is no greater than 7 cm. For example, the interval between the adjacent transparent bumps 71 may be 7 cm, 6.5 cm, 6 cm, 5.5 cm, 5 cm, 4.5 cm, 4 cm, 3.5 cm, 3 cm, 2.5 cm, 2 cm, 1.5 cm, 1 cm, 0.5 cm, or the like, so that a small interval is kept between two adjacent support points, which effectively prevents the possible contact of the partial region of the back-contact solar cell 31 with the transfer table. When the interval between the adjacent transparent bumps 71 is greater than 7 cm, a distance between two adjacent support points is excessively large, resulting in local damages due to easy contact of a part of the back-contact solar cell 31 between the two adjacent support points with the transfer table.

In an embodiment, a projected area of the transparent bumps 71 on the surface of the back-contact solar cell 31 is less than 10 mm². For example, the projected area of the transparent bumps 71 on the surface of the back-contact solar cell 31 may be 10 mm², 9.5 mm², 9 mm², 8.5 mm², 8 mm², 7.5 mm², 7 mm², 6.5 mm², 6 mm², 5.5 mm², 5 mm², 4.5 mm², 4 mm², 3.5 mm², 3 mm², 2.5 mm², 2 mm², 1.5 mm², 1 mm², 0.5 mm², or the like, which reduces absorption of the incident light by the transparent bumps 71 as much as possible and improves the conversion efficiency of the solar energy.

In an embodiment, a height of each of the transparent bumps 71 is less than 0.5 mm. For example, the height of the transparent bump 71 may be 0.5 mm, 0.45 mm, 0.4 mm, 0.35 mm, 0.3 mm, 0.25 mm, 0.2 mm, 0.15 mm, 0.1 mm, 0.05 mm, or the like. On the one hand, the transparent bump 71 maintains high structural strength, thereby providing stable support for the back-contact solar cell 31. On the other hand, an influence of formation of pressure points inside the photovoltaic module by the transparent bumps 71 on an overall load capacity of the photovoltaic module is prevented.

In an embodiment, referring to FIG. 5 to FIG. 8, there are gaps (i.e., D1 is greater than 0 and D2 is greater than 0 in the drawings) between the transparent bump 71 and edges of the back-contact solar cell 31, and when the back-contact solar cell 31 is required to be scribed, there is a gap (i.e., D3 is greater than 0 in the drawings) between the transparent bump 71 and a cutting line 32 of the back-contact solar cell 31, so as to prevent warping after the transparent bump 71 is cured and improve flatness of the transparent bump 71.

In an embodiment, the transparent support layer is made of any one of an insulating adhesive (any one of silicone, epoxy, and acrylic systems), a hot melt adhesive, PET, EVA, and POE, which can form better adhesion on the surface of the back-contact solar cell 31 and prevent damages such as delamination during lamination of the back-contact photovoltaic module, can have good light transmission, and produce no optical gain effect. That is, the transparent support layer is only light-transmitting and does not produce any optical gain effect, and the light passes through the transparent support layer and irradiates the surface of the back-contact solar cell 31, which is not significantly different from direct irradiation on the surface of the back-contact solar cell 31. Therefore, an influence of the transparent support layer on the incident light can be reduced as much as possible, and uniformity of distribution of the incident light on the surface of the back-contact solar cell 31 can be maintained. It may be understood that the transparent support layer may alternatively be made of a material with an optical gain effect such as PVB, EPE, or EP, as long as the selected material has high adhesion and high transparency.

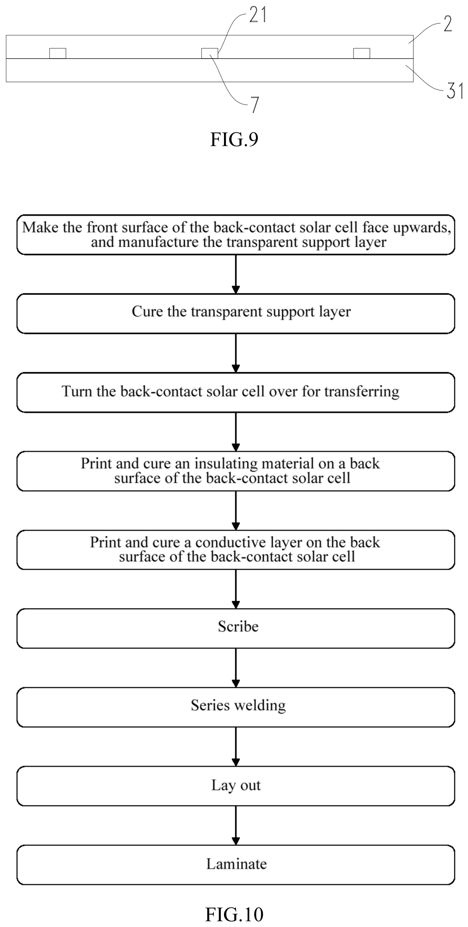

In an embodiment, referring to FIG. 9, a side of the upper adhesive film layer 2 facing the back-contact solar cell 31 is provided with a groove 21, and the groove 21 fits the transparent support layer. That is, the groove 21 is arranged at a position of the upper adhesive film layer 2 corresponding to the transparent support layer, a shape and a size of the groove 21 are adapted to those of the transparent support layer, and a depth of the groove 21 is adapted to a height of the transparent support layer, so that the transparent support layer can be stretched into the groove 21. Moreover, the groove 21 can be just filled up with the transparent support layer, so as to form a flat photovoltaic module structure. In addition, through the fitting between the groove 21 and the transparent support layer, positioning between the solar cell layer 3 and the upper adhesive film layer 2 can be achieved, which prevents slipping of the back-contact solar cell 31 during the lamination.

As shown in FIG. 10, some embodiments of the present disclosure provide a manufacturing method for a back-contact photovoltaic module. The back-contact photovoltaic module includes a glass substrate 1, an upper adhesive film layer 2, a solar cell layer 3, a lower adhesive film layer 4, and a back sheet 5 arranged in sequence from top to bottom. The solar cell layer 3 includes back-contact solar cells 31, a front surface of each of the back-contact solar cells 31 is provided with a transparent support layer, the transparent support layer protrudes from a surface of the back-contact solar cell 31, and the transparent support layer covers a partial region of the front surface. The manufacturing method includes: making the front surface of the back-contact solar cell 31 face upwards, and manufacturing the transparent support layer on the front surface of the back-contact solar cell 31; curing the transparent support layer; turning the back-contact solar cell 31 over for transfer; and packaging the back-contact solar cells 31 to form the back-contact photovoltaic module.

The front surface of the back-contact solar cell 31 is provided with the transparent support layer, and the transparent support layer is made of a transparent material, so that incident light can pass therethrough smoothly. The transparent support layer protrudes from the surface of the back-contact solar cell 31, so that the transparent support layer can protect the front surface of the back-contact solar cell 31 and prevent direct contact of the surface of the back-contact solar cell 31 with the transfer table, thereby reducing a risk of scratches to the back-contact photovoltaic module. The transparent support layer covers the partial region of the front surface. That is, the transparent support layer does not completely cover the front surface of the back-contact solar cell 31, which further reduces absorption of the incident light by the transparent support layer, thereby improving the conversion efficiency of the solar energy.

In an embodiment, the transparent support layer may be manufactured on the front surface of the back-contact solar cell 31 by glue printing. The transparent support layer may be cured by thermosetting or photo-curing, or both.

In an embodiment, the packaging the back-contact solar cells 31 to form the back-contact photovoltaic module may include: printing and curing an insulating material on a back surface of the back-contact solar cell 31; printing and curing a conductive layer on the back surface of the back-contact solar cell 31; scribing; series welding; layout; and lamination. The frame 6 and the junction box may be further mounted after the lamination.

The printing and curing of the insulating material on the back surface of the back-contact solar cell 31 realizes insulation between positive and negative electrodes and prevents a short circuit caused by contact of solder strips during soldering. The printing and curing of the conductive layer on the back surface of the back-contact solar cell 31 realizes interconnection of the back-contact solar cells 31. Scribing means reducing on-chip current transfer losses in the module by cutting the whole cell into small pieces.

The above descriptions are only preferred embodiments of the present disclosure, and are not intended to limit the present disclosure. For those skilled in the art, various modifications and changes may be made to the present disclosure. Any modifications, equivalent replacements, improvements, and the like made within the spirit and the principle of the present disclosure shall fall within the protection scope of the present disclosure.

## Claims

1. A back-contact solar cell, comprising:
a front surface and a rear surface arranged opposite to each other,
wherein the back-contact solar cell (31) is provided with transparent bumps (71) protruding from the front surface of the back-contact solar cell (31) and covering a partial region of the front surface, and
an interval between adjacent transparent bumps (71) is equal to or less than 7 cm.

2. The back-contact solar cell according to claim 1, wherein an area ratio of the transparent bumps (71) to the front surface ranges from 1% to 80%.

3. The back-contact solar cell according to claim 1, wherein an area ratio of the transparent bumps (71) to the front surface ranges from 2% to 30%.

4. The back-contact solar cell according to any one of the preceding claims, wherein the transparent bumps (71) are evenly distributed on the surface of the back-contact solar cell (31).

5. The back-contact solar cell according to any one of the preceding claims, wherein a number of the transparent bumps (71) is equal to or more than 9.

6. The back-contact solar cell according to any one of the preceding claims, wherein a projected area of the transparent bumps (71) on the surface of the back-contact solar cell (31) is less than 10 mm².

7. The back-contact solar cell according to any one of the preceding claims, wherein a height of each of the transparent bumps (71) is less than 0.5 mm.

8. The back-contact solar cell according to any one of the preceding claims, wherein a gap is provided between each of the transparent bumps (71) and an edge of each of the back-contact solar cells (31).

9. The back-contact solar cell according to any one of the preceding claims, wherein a gap is provided between each of the transparent bumps (71) and a cutting line (32) of the back-contact solar cell (31).

10. The back-contact solar cell according to claim 1, wherein the transparent bumps (71) are unevenly distributed on the surface of the back-contact solar cell (31) in a random manner.

11. A back-contact photovoltaic module, comprising:
a glass substrate (1),
an upper adhesive film layer (2),
a solar cell layer (3),
a lower adhesive film layer (4), and
a back sheet (5) arranged in sequence from top to bottom,
wherein the solar cell layer (3) comprises at least one back-contact solar cell (31) according to any one of claims 1 to 10.

12. The back-contact photovoltaic module according to claim 11, wherein a side of the upper adhesive film layer (2) facing the back-contact solar cell (31) is provided with grooves (21), and the grooves (21) fit the transparent bumps (71).

13. The back-contact photovoltaic module according to claim 12, wherein a depth of the groove (21) is adapted to a height of the transparent bump (71), so that the transparent bump (71) extends into the groove 21 to fill up the groove (21).

14. The back-contact photovoltaic module according to any one of claims 11 to 13, further comprising:
a frame (6) arranged on an edge of the back-contact photovoltaic module, and
a junction box configured to connect a circuit of the back-contact photovoltaic module and an external load circuit.

15. A method for manufacturing a back-contact photovoltaic module, wherein the back-contact photovoltaic module comprises a glass substrate (1), an upper adhesive film layer (2), a solar cell layer (3), a lower adhesive film layer (4), and a back sheet (5) arranged in sequence from top to bottom; and
wherein the solar cell layer (3) comprises back-contact solar cells (31), and a front surface of each of the back-contact solar cells (31) is provided with a transparent bumps (71), the transparent bumps (71) protrudes from a surface of the back-contact solar cell (31), and the transparent bumps (71) covers a partial region of the front surface, and an interval between adjacent transparent bumps (71) is equal to or less than 7 cm; and
wherein the method comprises:
making the front surface of the back-contact solar cell (31) face upwards, and manufacturing the transparent bumps (71) on the front surface of the back-contact solar cell (31);
curing the transparent bumps (71);
turning the back-contact solar cell (31) over for transferring; and
packaging the back-contact solar cell (31) to form the back-contact photovoltaic module.
